(19) Europäisches Patentamt
European Patent Office
Office européen des brevets

(11) EP 0 612 166 B1

(12) # EUROPEAN PATENT SPECIFICATION

(45) Date of publication and mention of the grant of the patent:
**27.10.1999 Bulletin 1999/43**

(51) Int Cl.⁶: **H04L 1/00**, H03M 13/00

(21) Application number: **94301202.1**

(22) Date of filing: **21.02.1994**

(54) **A method and apparatus for error-control coding in a digital data communications system**

Verfahren und Gerät für Kodage zur Fehlerkontrolle in einem digitalen Datenkommunikationssystem

Méthode et appareil de codage de contrôle d'erreurs dans un système de communication de données numériques

(84) Designated Contracting States:
**DE FR GB IT NL SE**

(30) Priority: **19.02.1993 JP 3003693**
**21.04.1993 JP 9345593**

(43) Date of publication of application:
**24.08.1994 Bulletin 1994/34**

(73) Proprietor: **NEC CORPORATION**
**Tokyo (JP)**

(72) Inventor: **Ikekawa, Masao, c/o NEC Corporation**
**Tokyo (JP)**

(74) Representative: **Orchard, Oliver John**
**JOHN ORCHARD & CO.**
**Staple Inn Buildings North**
**High Holborn**
**London WC1V 7PZ (GB)**

(56) References cited:
**WO-A-88/09967** **GB-A- 2 238 933**
**US-A- 4 355 392**

- **IEEE TRANSACTIONS ON VEHICULAR TECHNOLOGY, vol.41, no.2, May 1992, NEW YORK US pages 177 - 189, XP307100 G. D'ARIA / F. MURATORE / V. PALESTINI: 'Simulation and Performance of the Pan-European Land Mobile Radio System.'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 612 166 B1

## Description

The present invention relates generally to a method and apparatus for implementing error-control coding in a digital data communications system, and more specifically to such a method and apparatus for correcting and/or detecting errors induced during data transmission.

In order to correct and/or detect channel bit errors induced during digital data transmission, it is well known in the art to utilize error-control coding techniques.

These techniques are disclosed in a book entitled "Essential of Error-coding Techniques' edited by Hideki IMAI and published 1990 by Academic Press, Inc., San Diego, California 92101, U.S.A., and a book entitled "Error Control Coding: Fundamentals and Applications' by Shu tin, et al., published 1983 by Prentice-Hall, Inc., Englewood Cliffs, N.J. 07632, U.S.A., merely by way of example.

Redundant bits are added to each binary code word to be transmitted in order to provide the code with the capability of combating the channel noises. A Viterbi algorithm is able to exhibit error correcting capability almost equally over the entire bits of a code word. However, it is sometimes required to transmit a special bit(s) of each code word with high reliability as compared with the remaining bits of the code word. In order to realize such a requirement, according to prior art, it has been inevitably required that a plurality of pairs of an encoder and decoder, having different error-control capability or functions, be provided. However, the above mentioned known techniques suffer from the drawback that an overall system is rendered large and complex. Further, the freedom of the system design is reduced.

In an article by G. D'Aria, et al. entitled "Simulation and Performance of the Pan-European Land Mobile Radio System" in Vol. 41, No. 2, May 1992 of the IEEE Transactions on Vehicular Technology, New York, U.S.A., on pages 177 to 189, there is described the performance of the compact-spectrum constant-envelope modulation chosen by ETSI/GSM, together with concatenated block and convolutional coding, Viterbi adaptive equalization and soft-decision Viterbi decoding to cope with the severe time-and frequency-selective distortions caused by propagation phenomena, properly modelled for computer simulation.

The specification of UK patent application number 2,238,933, which was published on June 12 1991, describes a low-overhead method of protecting multi-pulse speech coders from the effects of severe random or fading bit pattern errors which combines a standard error correcting code (convolutional rate ½ coding and Viterbi trellis decoding) for protection against random errors with cyclic redundancy code (CRC) error detection for fading errors. Protection, which is applied only to the perceptually significant bits in a transmitted frame, takes place within the speech coder.

A specification which was published on December 15 1998 with International Patent Publication No. W088/9967 described a method of error correction in digitally encoded speech in which sub-band coding was preferably applied to an input signal, sample information, and side information. An error detection code was applied to at least a portion of the side information, and an error correction code was applied over the side information and the error detection code. A second error detection code was applied to the error correction code and the information signals and the error detection and correction codes were multiplexed.

Features of arrangements to be described below, by way of example, in illustration of the present invention are that in error-control coding important bit(s) is/are selected from a bit sequence and then subjected to block encoding for correctly transmitting the same, and that apparatus for such error-control coding has means for selecting important bit(s) from a bit sequence and then subjecting them to block encoding for correct transmission.

In one arrangement to be described below, by way of example, in illustration of the invention, in order to ensure that a predetermined bit or bits of a bit sequence to be transmitted are correctly received by a receiver, the predetermined bit is first extracted from the bit sequence. The extracted bit is then encoded and combined with a bit sequence which has not been extracted. The combined bit sequence is convolutionally encoded and then transmitted to the receiver. The transmitted bit sequence undergoes maximum-likelihood decoding using a Viterbi algorithm, wherein the information of the predetermined bit encoding is used to decode the predetermined bit. Subsequently, the encoded predetermined bit portion is extracted and subjected to block decoding.

The following description and drawings disclose, by means of examples, the invention which is characterised in the appended claims, whose terms determine the extent of the protection conferred hereby.

In the drawings:-

Fig. 1 is a block diagram schematically showing a first arrangement illustrative of the present invention,

Fig. 2A is a sketch schematically showing waveforms of an analog signal to be encoded,

Fig. 2B is a diagram schematically showing burst digital signals to be transmitted,

Fig. 3 is a block diagram schematically showing an arrangement of a block shown in Fig. 1,

Fig. 4 is a known encoder state diagram by means of which the operations of the first arrangement are discussed,

Figs. 5-7 each show a trellis diagram by means which the operations of the first arrangement are discussed,

Fig. 8 is a block diagram schematically showing a transmitter of a second arrangement illustrative of the invention,

Fig. 9 is a block diagram schematically showing a receiver of the second arrangement,

Fig. 10 is a block diagram schematically showing a transmitter of yet a third arrangement illustrative of the invention, and

Fig. 11 is a block diagram schematically showing a receiver of the third arrangement.

The arrangement shown in Fig. 1 generally includes a transmitter 10 which is interconnected to a receiver 12 via a transmission channel 14.

The transmitter 10 includes a message source 16, a source encoder 18, a bit selector 20, a block encoder 22, a bit combiner (or bit merger) 24, and a convolutional encoder 26, all of which are coupled as shown. On the other hand, the receiver 12 includes a maximum-likelihood decoder 28 which operates under a Viterbi algorithm, a bit selector 304 a block decoder 32, a bit combiner 34, and a source decoder 36, all of which are coupled as illustrated.

Merely for the sake of a better understanding of the first arrangement, it is assumed that the message source 16 takes the form of an analog speech signal source. The wave form of the speech signal (denoted by "S1"), obtained from the source 16, is schematically shown in Fig. 2A. The speech signal S1 undergoes digital signal processing at the source encoder 18. That is, the speech signal is initially digitized at a time interval of 40 ms. (for example) which is called a frame. Subsequently, the digitized speech signal is compressed and then applied to the bit selector 20 as a bit sequence 52 in a burst mode, as best seen from Fig. 2B. If the bit rate of digitization is 4K bits/sec., it is readily appreciated that each frame of 40 ms. contains 160 bits. It is further assumed that the first bit of the burst signal is a mode bit indicating whether the corresponding frame is a voice frame or a silence frame. This mode bit appearing at the beginning of each frame is very important and hence has to be correctly transmitted to the receiver 12. The second to the last bit of each frame is not so important as compared with the mode bit.

The bit selector 20 selects the above mentioned mode bit from the incoming frame data. This bit selection is carried out under the control of a bit select signal applied to the selector 20 from a central processor unit (CPU) (not shown) which supervises the overall operation of the transmitter 10. The other bits which have not been selected by the bit selector 20 are directly supplied to the bit combiner 24.

The mode bit thus selected is fed to the block encoder 22 which, in this particular arrangement, outputs "01" and "10" when the applied mode bit assumes "0" and "1", respectively. The bit combiner 24 combines or merges the two outputs of the block encoder 22 and the bit selector 20 in this order. A bit sequence (depicted by "A") from the bit combiner 24 is applied to the convolutional encoder 26.

In the foregoing, it is assumed that a given frame of the bit sequence S2 output from the source encoder 18 is represented by

$$S2 = (0\ 0\ 0\ 1\ .\ .\ .\ .\ ) \qquad (1)$$

As mentioned above, if the mode bit is "0" then the output of the block encoder 22 assumes "01". Thus, the combiner 24 issues the output A which is given by

$$A = (0\ 1\ 0\ 0\ 1\ .\ .\ .\ .\ ) \qquad (2)$$

Reference is made to Fig. 3 wherein the arrangement of the convolutional encoder 26 is shown in block diagram form. The encoder 26 is of a conventional type and includes three delay lines or shift registers (denoted by $D_n$, $D_{n-1}$ and $D_{n-2}$), two modulo-2 adders 40a-40b, and a parallel/serial (P/S) converter 42, in this particular embodiment. Thus, the constraint length (K) of the encoder 26 is 3 (three) while the code rate (R) thereof is ½. The arrangement illustrated in Fig. 3 is well known in the art.

Fig. 4 is a state diagram of the encoder 26. In Fig. 4, two consecutive bits within each of ovals indicates the bits held in the last two delay lines $D_{n-2}$ and $D_{n-1}$, and indicates an encoder state. The encoder states (00), (01), (10) and (11) are connected or looped by solid and broken arrow lines. If a bit "I' is applied to the encoder 26, the encoder state is shifted to the other state or returned to the same state along the solid arrow. On the other hand, if a bit "0" is applied to the encoder 26 then the encoder state is shifted to the other state or returned to the same state along the broken arrow. The outputs of the convolutional encoder 26 are represented along the corresponding arrows such as (00), (01), (10) and (11).

The encoder 26 is set to the state (00) before a burst type bit sequence is newly applied. Therefore, if the mode bit (viz., first bit) assuming "0" is applied to the encoder 26, the encoder state (00) remains unchanged. In this case, the output of the encoder 26 is (00). Following this, if the second bit assuming "1" is applied to the encoder 26, the encoder 26 takes the state (01) and outputs a two bits sequence (11). Thereafter, similar operations continue. Thus, if the bit sequence A of (0 1 0 0 1 . . .) is applied to the convolutional encoder 26 as mentioned in expression (2), the bit sequence C obtained from the encoder 26 and then sent over the channel 14 is given by

$$C = (00\ 11\ 01\ 11\ 11\ .\ .\ .\ .) \qquad (3)$$

The bit sequence C is transmitted over the channel 14 and applied to the receiver 12 as a bit sequence CC. It is assumed that the bit sequence C is subjected to bit errors during transmission and that the bit sequence CC is represented by

$$CC = (01\ 11\ 01\ 01\ 11\ .\ .\ .) \qquad (4)$$

The operation of the maximum-likelihood decoder 28 of the receiver 12 will be discussed with reference to the trellis diagrams shown in Figs. 5-7. The above mentioned bit sequences A, C and CC, given by the expressions (2)-(4) are shown at the top portions of each of Figs. 5-7. It is well known that the trellis diagram represents the encoder states (see Fig. 4) along a time axis. It should be noted in Figs. 5-7 that numerals above the encoder states represent respectively "decimal numbers" indicating path metrics.

Reference is made to Fig. 5. The decoder 28 is initialized such that the path metric of the encoder state (00) is set to 0 while each of the remaining path metrics of the other states (01), (10) and (11) is set to a sufficiently large number such as 10(decimal) in this particular embodiment. These path metrics are illustrated at the first time point (t=0).

The decoder 28 initially decodes the first two bits (viz., encoded mode bit) using the previously known block code information (01 and 10). This information has been stored in a suitable memory in the receiver 12 and is applied to the decoder 28.

The first bit sequences have been block encoded at the encoder 22, and thus it is appreciated that survivor paths at t=1 and t=2 are represented by two bold solid lines and two bold broken lines as illustrated.

A bit sequence of the survivor path extending to the state (00) at t=2 is (00), and hence, this path is unable to be finally selected. Further, a bit sequence of the survivor path extending to the state (01) at t=2 is (11). Therefore, this path is expected to finally be selected. On the other hand, the survivor path extending to the state (10) at t=2 can be expected to be chosen for determining the decoded sequence, while the survivor path extending to the state (11) at t=2 can not be expected to be used to determine the decoded sequence.

Therefore, in order to determine the following survivor paths, path metrics at the states (00) and (11), both at t=2, are set to a sufficiently large number, such as 10 (decimal) in this case, as shown in Fig. 6. This is to exclude the survivor paths which can not eventually be used for estimating the incoming bit sequence.

Subsequently, conventional decoding, according to a Viterbi algorithm, is implemented which is well known in the art and thus will not be discussed for the sake of brevity. Survivor paths determined up to t=5 are illustrated by bold solid and broken lines in Fig. 7.

The decoded bit sequence from the maximum-likelihood decoder 28 is then applied to the bit selector 30. This selector 30 implements the reverse operation of the counterpart thereof 20 in response to a bit select signal which has previously been stored in the receiver 12. The first two bits of the frame are applied to the block decoder 32 while the remaining bits are directly applied to the bit combiner 34. The bit selector 30 decodes the first two bits "0" or "1" and then applies the decoded bit to the bit combiner 34. The bit sequence aligned at the bit combiner 34 is applied to the source decoder 36 which produces an estimated message.

In the above first arrangement, the mode information is a single bit. However, it is possible to set the mode information to two or more than two bits. Further, the bit combiner 24 is arranged to insert the output of the block encoder 22 into a given position of the bit stream applied thereto from the bit selector 20.

Reference is now made to Figs. 8 and 9, wherein a second arrangement illustrative of the present invention is schematically shown in a block diagram. The second arrangement is an error-control coding apparatus which includes both error- correcting and error-detecting functions. Figs. 8 and 9 show respectively a transmitter and receiver of the second arrangement.

The transmitter shown in Fig. 8 further includes a switch 60 and two error-detecting encoders 62a and 62b as compared with the counterpart of the first arrangement. Accordingly, the blocks of Fig. 8, which have been referred to in the first arrangement, will be described only if they are directly relevant to the second arrangement.

The mode bit obtained from the bit selector 20 is applied to the switch 60 as a switch control signal. The remaining bits from the bit selector 20 is applied to the switch 60. If the mode bit assumes a logic "0", the switch 60 allows the incoming bit sequence to be applied to the error-detecting encoder 62a. Contrarily, if the mode bit assumes a logic "1" then the switch 60 applies the incoming bit sequence to the other encoder 62b.

As is known, an error-detecting encoder is to add redundant bits to a bit sequence (viz., detection bits) applied thereto for the purpose of error detection.

In the second arrangement, the encoders 62a and 62b add the same length of redundant bits to the bit sequences applied thereto. However, the two encoder 62a and 62b produce or arrange different redundant bits with each other. This is very preferable in the case in which significant bits are different depending on a logic level of the mode bit (viz., whether the frame data is a voice mode or not in this particular arrangement).

The receiver shown in Fig. 9 includes a switch 64 and two error-detecting decoders 64a and 64b in addition to the receiver 12 of the first arrangement. Accordingly, the blocks of Fig. 9 which have been referred to in the first arrangement, will be described only if they are directly relevant to the second arrangement.

The decoded mode bit obtained from the block decoder 32 is applied to the switch 64 as a switch control signal. The bit sequence except for the mode bit output from the bit selector 30, is applied to the switch 64. If the decoded mode bit (viz., switch control signal) assumes a logic "0", the switch 64 allows the incoming bit sequence to be applied to the error-detecting decoder 64a. Contrarily, if the decoded mode bit assumes a logic "1", the switch 64 applies the incoming bit sequence to the other decoder 64b.

Each of the error detecting decoders 64a and 64b outputs an error detect bit indicating whether or not the received bit sequence includes an error. Further, the decoders 64a and 64b apply respectively the decoded bit sequences to the bit combiner 34. The following operations are essentially the same as those mentioned in connection with the first arrangement.

Another feature of the second arrangement is that, if the mode bit is erroneously transmitted, each of the decoders 64a and 64b issues the error detect bit which indicates the presence of a transmission error. This is very advantageous in that the mode bit is the nature of being correctly transmitted as mentioned above.

Reference is made to Figs. 10 and 11, wherein a third arrangement which illustrates the present invention is schematically shown in block diagram. The third arrangement is an error-control coding apparatus which includes both error-correcting and error-detecting functions. Figs. 10 and 11 show respectively a transmitter and receiver of the third embodiment.

The transmitter shown in Fig. 10 further includes a bit selector 70 and an error-detecting encoder 72 as compared with the counterpart 10 of the first arrangement. Accordingly, the blocks of Fig. 10 which have been referred to in the first arrangement, will be described only if they are directly relevant to the third arrangement.

The mode bit obtained from the bit selector 20 is applied to the bit selector 70 as a bit select signal. The remaining bits of a frame, output from the bit selector 20, are applied to the bit selector 70. The mode bit applied to the bit selector 70 determines which portion of the bit sequence applied thereto should be transferred to the error-detecting encoder 72. The number of consecutive bits selected, depending on the logic level of the mode bit, is usually different from that selected in response to the other logic level of the mode bit. This is very advantageous in the case in which significant bits are different in position depending on the logic levels of the mode bit (viz., whether the frame data is in a voice mode or not in this particular arrangement). The bit combiner 24 combines the outputs of the blocks 22, 70 and 72.

Fig. 11 shows a receiver of the third arrangement. The operation of this arrangement is readily appreciated from the foregoing and thus, the description thereof will be omitted for brevity.

It will be understood that the above disclosure is representative of only three possible arrangements, by way of example, and that variations and modifications, as well as other arrangements, may be conceived within the scope of the protection sought by the appended claims.

## Claims

**1.** An apparatus for error-control coding, including:

a selector (20) for selecting at least one bit from a bit sequence (S2) applied thereto, the at least one bit being selected to be transmitted with a higher reliability than the remaining bits of the bit sequence, and the at least one bit occupying any position within the bit sequence,
a first encoder (22) for block encoding the at least one bit applied thereto from the selector, thereby forming a valid error-control sequence, the valid error- control sequence being adapted to become an invalid error-control sequence according to later transmission errors,
a combiner (24) for combining the output of the first encoder and the bits in the bit sequence which have not been selected by the selector,
a second encoder (26) for implementing convolutional encoding to the bit sequence output from the combiner,
a first decoder (28) for implementing maximum-likelihood decoding to the bit sequence transmitted, and
a second decoder (32) for block decoding the block encoded bit data.

**2.** An apparatus for error-control coding, which includes a data transmitter (10) and a data receiver (12) interconnected via a transmission channel (14), the data transmitter including

a first bit selector (20) for selecting at least one predetermined bit from a bit sequence (S2) applied thereto, the first bit selector (20) outputting the at least one predetermined bit and a first bit sequence which does not include the at least one predetermined bit,
a first encoder (22), coupled to the first bit selector (20) for encoding the at least one predetermined bit and outputting a second bit sequence which corresponds to the at least one predetermined bit which has been encoded by the first encoder (22),
first and second error detecting encoders (62a, 62b) which are connected in parallel with each other,
a first switching means (60) coupled to receive the first bit sequence and the at least one predetermined bit, the first switching means (60) selectively applying the first bit sequence to one of the first and second error detecting encoders (62a, 62b) depending on the at least one predetermined bit,

a first bit combiner (24) coupled to combine the second bit sequence and one of outputs of the first and second error detecting encoders (62a, 62b), the first bit combiner (24) outputting a combined bit sequence (A), and
a second encoder (26) for convolutionally encoding the combined bit sequence into a third bit sequence which is transmitted to the data receiver (12) via the transmission channel (14).

**3.** An apparatus as claimed in claim 2, wherein the data receiver includes

a first decoder (28) for decoding the third bit sequence, applied thereto over the transmission channel, using a Viterbi algorithm,
a second bit selector (30), coupled to the first decoder, for selecting a fourth bit sequence from an output of the first decoder, the fourth bit sequence corresponding to the second bit sequence, the second bit selector (30) outputting the fourth bit sequence and a fifth bit sequence which does not include the fourth bit sequence,
a second decoder (32) coupled to decode the fourth bit sequence, the second decoder (32) outputting at least one bit which corresponds to the at least one predetermined bit,
first and second error detecting decoders (64a, 64b) which are connected in parallel with each other,
a second switching means (64) coupled to receive the fifth bit sequence and the at least one bit, the second switching means (64) selectively applying the fifth bit sequence to one of the first and second error detecting decoders (64a, 64b) depending on the at least one bit, and
a second bit combiner (34) coupled to combine the at least one bit and an output of one of the first and second error detecting decoders (64a, 64b).

**4.** An apparatus for error-control coding, which includes a data transmitter (10) and a data receiver (12) interconnected via a transmission channel (14), the data transmitter including,

a first bit selector (20) for selecting at least one predetermined bit from a bit sequence (S2) applied thereto, the first bit selector (20) outputting the at least one predetermined bit and a first bit sequence which does not include the at least one predetermined bit,
a first encoder (22), coupled to the first bit selector (20), for encoding the at least one predetermined bit and outputting a second bit sequence which corresponds to the at least one predetermined bit which has been encoded by the first encoder (22),
a second bit selector (70) coupled to receive the first bit sequence and the at least one predetermined bit, the second bit selector (70) selecting a third bit sequence of a predetermined length from the first bit sequence depending on the at least one predetermined bit, the second bit selector (70) outputting a fourth bit sequence which does not include the third bit sequence,
an error detecting encoder (72) which receives the third bit sequence and adds redundant bits thereto, the error detecting encoder (72) outputting a fifth bit sequence which includes the third bit sequence and the redundant bits,
a first bit combiner (24) coupled to combine the second, fourth and fifth bit sequences, the first bit combiner (24) outputting a combined bit sequence, and
a second encoder (26) for convolutionally encoding the combined bit sequence into a sixth bit sequence which is transmitted to the data receiver (12) via the transmission channel (14).

**5.** An apparatus as claimed in claim 4, wherein the data receiver includes

a first decoder (28) for decoding the sixth bit sequence applied thereto over the transmission channel (14), using a Viterbi algorithm,
a third bit selector (30), coupled to the first decoder (28), for selecting a seventh bit sequence from an output of the first decoder (28), the seventh bit sequence corresponding to the second bit sequence, the third bit selector (30) outputting the seventh bit sequence and an eighth bit sequence which does not include the seventh bit sequence,
a second decoder (32) coupled to decode the seventh bit sequence, the second decoder (32) outputting at least one bit which corresponds to the at least one predetermined bit,
a fourth bit selector (74) coupled to receive the eighth bit sequence from the third bit selector (30) and receive the at least one bit from the second decoder (32), the fourth bit selector (74) selecting ninth and tenth bit sequences which respectively correspond to the fourth and fifth bit sequences,
an error detecting decoder (76) arranged to decode the tenth bit sequence, and
a second bit combiner (34) coupled to combine the at least one bit from the second decoder (32), the ninth bit sequence and an output of the error detecting encoder (76).

**6.** A method for error-control including the steps of

selecting at least one bit from an initial bit sequence (S2), the at least one bit occupying any position within the initial bit sequence
encoding the at least one bit thereby forming an encoded bit,
combining the encoded bit with bits in the initial bit sequence which are not selected thereby forming a second bit sequence (A),
convolutionally encoding the second bit sequence thereby forming a third bit sequence (C),
decoding the third bit sequence using maximum-likelihood decoding to form a fourth bit sequence, and
decoding the fourth bit sequence.

**7.** A method as claimed in claim 6, wherein the step of selecting includes a mode bit from the initial bit sequence.

**8.** A method as claimed in claim 6, wherein the step of encoding encodes a logic "0" as "01" and encodes a logic '1' as "10".

**Patentansprüche**

**1.** Vorrichtung zur Fehlerkontrollcodierung mit:

einem Selektor (20) zum Wählen mindestens eines Bits aus einer an diesen angelegten Bitsequenz (S2), wobei das mindestens eine Bit gewählt wird, um mit einer höheren Zuverlässigkeit als die verbleibenden Bits der Bitsequenz übertragen zu werden, und das mindestens eine Bit irgendeine Position in der Bitsequenz belegt,
einem ersten Codierer (22) zum Blockcodieren des mindestens einen an diesen angelegten Bits vom Selektor, wodurch eine gültige Fehlerkontrollsequenz entsteht, wobei die gültige Fehlerkontrollsequenz geeignet ist, eine ungültige Fehlerkontrollsequenz gemäß späteren Übertragungsfehlern zu werden,
einem Kombinierer (24) zum Kombinieren des Ausgangssignals des ersten Codierers und der Bits in der Bitsequenz, die nicht vom Selektor gewählt worden sind,
einem zweiten Codierer (26) zum Implementieren einer Faltungscodierung an der vom Kombinierer ausgegebenen Bitsequenz,
einem ersten Decodierer (28) zum Implementieren einer Maximum-likelihood-Decodierung an der übertragenen Bitsequenz und
einem zweiten Decodierer (32) zum Blockdecodieren der blockcodierten Bitdaten.

**2.** Vorrichtung zur Fehlerkontrollcodierung, die einen Datensender (10) und einen Datenempfänger (12) aufweist, die über einen Übertragungskanal (14) miteinander verbunden sind, wobei der Datensender aufweist:

einen ersten Bitselektor (20) zum Wählen mindestens eines vorbestimmten Bits aus einer an diesen angelegten Bitsequenz (S2), wobei der erste Bitselektor (20) das mindestens eine vorbestimmte Bit und eine erste Bitsequenz ausgibt, die das mindestens eine vorbestimmte Bit nicht aufweist,
einen ersten Codierer (22), der mit dem ersten Bitselektor (20) gekoppelt ist, zum Codieren des mindestens einen vorbestimmten Bits und zum Ausgeben einer zweiten Bitsequenz, die dem mindestens einen vorbestimmten Bit entspricht, das vom ersten Codierer (22) codiert worden ist,
einen ersten und zweiten Fehlerermittlungscodierer (62a, 62b), die miteinander parallelgeschaltet sind,
eine erste Schalteinrichtung (60), die so gekoppelt ist, daß die erste Bitsequenz und das mindestens eine vorbestimmte Bit empfangen werden können, wobei die erste Schalteinrichtung (60) die erste Bitsequenz in Abhängigkeit von dem mindestens einen vorbestimmten Bit entweder an den ersten oder zweiten Fehlerermittlungscodierer (62a, 62b) anlegt,
einen ersten Bitkombinierer (24), der so gekoppelt ist, daß die zweite Bitsequenz und eines der Ausgangssignale des ersten und des zweiten Fehlerermittlungscodierer (62a, 62b) kombiniert werden können, wobei der erste Bitkombinierer (24) eine kombinierte Bitsequenz (A) ausgibt, und
einen zweiten Codierer (26) zum Faltungscodieren der kombinierten Bitsequenz in eine dritte Bitsequenz, die über den Übertragungskanal (14) an den Datenempfänger (12) übertragen wird.

**3.** Vorrichtung nach Anspruch 2, wobei der Datenempfänger aufweist:

einen ersten Decodierer (28) zum Decodieren der über den Übertragungskanal an diesen angelegten dritten Bitsequenz unter Verwendung eines Viterbi-Algorithmus,
einen zweiten Bitselektor (30), der mit dem ersten Decodierer gekoppelt ist, zum Wählen einer vierten Bitsequenz aus einem Ausgangssignal des ersten Decodierers, wobei die vierte Bitsequenz der zweiten Bitsequenz entspricht und der zweite Bitselektor (30) die vierte Bitsequenz und eine fünfte Bitsequenz ausgibt, die die vierte Bitsequenz nicht aufweist,

einen zweiten Decodierer (32), der so gekoppelt ist, daß die vierte Bitsequenz codiert werden kann, wobei der zweite Decodierer (32) mindestens ein Bit ausgibt, das dem mindestens einem vorbestimmten Bit entspricht,
einen ersten und zweiten Fehlerermittlungsdecodierer (64a, 64b), die miteinander parallelgeschaltet sind,
eine zweite Schalteinrichtung (64), die so gekoppelt ist, daß die fünfte Bitsequenz und das mindestens eine Bit empfangen werden können, wobei die zweite Schalteinrichtung (64) die fünfte Bitsequenz in Abhängigkeit von dem mindestens einen Bit entweder an den ersten oder zweiten Fehlerermittlungsdecodierer (64a, 64b) selektiv anlegt, und
einen zweiten Bitkombinierer (34), der so gekoppelt ist, daß das mindestens eine Bit und ein Ausgangssignal des ersten oder zweiten Fehlerermittlungsdecodierers (64a, 64b) kombiniert werden können.

**4.** Vorrichtung zur Fehlerkontrollcodierung, die einen Datensender (10) und einen Datenempfänger (12) aufweist, die über einen Übertragungskanal (14) miteinander verbunden sind, wobei der Datensender aufweist:

einen ersten Bitselektor (20) zum Wählen mindestens eines vorbestimmten Bits aus einer an diesen angelegten Bitsequenz (S2), wobei der erste Bitselektor (20) das mindestens eine vorbestimmte Bit und eine erste Bitsequenz ausgibt, die das mindestens eine vorbestimmte Bit nicht aufweist,
einen ersten Codierer (22), der mit dem ersten Bitselektor (20) gekoppelt ist, zum Codieren des mindestens einen vorbestimmten Bits und zum Ausgeben einer zweiten Bitsequenz, die dem mindestens einen vorbestimmten Bit entspricht, das vom ersten Codierer (22) codiert worden ist,
einen zweiten Bitselektor (70), der so gekoppelt ist, daß die erste Bitsequenz und das mindestens eine vorbestimmte Bit empfangen werden können, wobei der zweite Bitselektor (70) in Abhängigkeit von dem mindestens einen vorbestimmten Bit eine dritte Bitsequenz einer vorbestimmten Länge aus der ersten Bitsequenz wählt und der zweite Bitselektor (70) eine vierte Bitsequenz ausgibt, die die dritte Bitsequenz nicht aufweist,
einen Fehlerermittlungscodierer (72), der die dritte Bitsequenz empfängt und dieser redundante Bits hinzufügt, wobei der Fehlerermittlungscodierer (72) eine fünfte Bitsequenz ausgibt, die die dritte Bitsequenz und die redundanten Bits aufweist,
einen ersten Bitkombinierer (24), der so gekoppelt ist, daß die zweite, vierte und fünfte Bitsequenz kombiniert werden können, wobei der erste Bitkombinierer (24) eine kombinierte Bitsequenz ausgibt, und
einen zweiten Codierer (26) zum Faltungscodieren der kombinierten Bitsequenz in eine sechste Bitsequenz, die über den Übertragungskanal (14) an den Datenempfänger (12) übertragen wird.

**5.** Vorrichtung nach Anspruch 4, wobei der Datenempfänger aufweist:

einen ersten Decodierer (28) zum Decodieren der über den Übertragungskanal (14) an diesen angelegten sechsten Bitsequenz unter Verwendung eines Viterbi-Algorithmus,
einen dritten Bitselektor (30), der mit dem ersten Decodierer (28) gekoppelt ist, zum Wählen einer siebenten Bitsequenz aus einem Ausgangssignal des ersten Decodierers (28), wobei die siebente Bitsequenz der zweiten Bitsequenz entspricht und der dritte Bitselektor (30) die siebente Bitsequenz und eine achte Bitsequenz ausgibt, die die siebente Bitsequenz nicht aufweist,
einen zweiten Decodierer (32), der so gekoppelt ist, daß die siebente Bitsequenz decodiert werden kann, wobei der zweite Decodierer (32) mindestens ein Bit ausgibt, das dem mindestens einen vorbestimmten Bit entspricht,
einen vierten Bitselektor (74), der so gekoppelt ist, daß die achte Bitsequenz vom dritten Bitselektor (30) empfangen werden kann und das mindestens eine Bit vom zweiten Decodierer (32) empfangen werden kann, wobei der vierte Bitselektor (74) eine neunte und eine zehnte Bitsequenz wählt, die der vierten bzw. fünften Bitsequenz entsprechen,
einen Fehlerermittlungsdecodierer (76), der so eingerichtet ist, daß die zehnte Bitsequenz decodiert werden kann, und
einen zweiten Bitkombinierer (34), der so gekoppelt ist, daß das mindestens eine Bit vom zweiten Decodierer (32), die neunte Bitsequenz und ein Ausgangssignal des Fehlerermittlungsdecodierers (76) kombiniert werden können.

**6.** Verfahren zur Fehlerkontrolle mit den Schritten:

Wählen mindestens eines Bits aus einer Anfangsbitsequenz (S2), wobei das mindestens eine Bit irgendeine Position in der Anfangsbitsequenz belegt,
Codieren des mindestens einen Bits, wodurch ein codiertes Bit entsteht,

Kombinieren des codierten Bits mit Bits in der Anfangsbitsequenz, die nicht gewählt sind, wodurch eine zweite Bitsequenz (A) entsteht, Faltungscodieren der zweiten Bitsequenz, wodurch eine dritte Bitsequenz (C) entsteht, Decodieren der dritten Bitsequenz unter Verwendung einer Maximum-likelihood-Decodierung, um eine vierte Bitsequenz zu bilden, und Decodieren der vierten Bitsequenz.

**7.** Verfahren nach Anspruch 6, wobei der Schritt des Wählens ein Modusbit aus der Anfangsbitsequenz aufweist.

**8.** Verfahren nach Anspruch 6, wobei der Schritt des Codierens eine logische "0" als "01" codiert und eine logische "1" als "10" codiert.

**Revendications**

**1.** Appareil de codage de contrôle d'erreurs, comportant :

un sélecteur (20) pour choisir au moins un bit dans une séquence binaire (S2) qui lui est appliquée, l'au moins un bit étant choisi pour être transmis avec une plus grande fiabilité que les bits restants de la séquence binaire, et l'au moins un bit occupant une position quelconque dans la séquence binaire,
un premier codeur (22) pour coder par blocs l'au moins un bit qui lui est appliqué par le sélecteur, afin de former une séquence de contrôle d'erreurs valable, la séquence de contrôle d'erreurs valable étant conçue pour devenir une séquence de contrôle non valable selon les erreurs de transmission trouvées ultérieurement,
un multiplexeur (24) pour combiner la sortie du premier codeur et les bits de la séquence binaire qui n'ont pas été choisis par le sélecteur,
un deuxième codeur (26) pour effectuer un codage convolutionnel de la séquence binaire sortant du multiplexeur,
un premier décodeur (28) pour effectuer un décodage de maximum de vraisemblance de la séquence binaire transmise, et
un deuxième décodeur (32) pour décoder par blocs les données binaires codées par blocs.

**2.** Appareil de codage de contrôle d'erreurs, comportant un émetteur de données (10) et un récepteur de données (12) interconnectés par l'intermédiaire d'une voie de transmission (14), l'émetteur de données comportant

un premier sélecteur de bits (20) pour choisir au moins un bit prédéterminé dans une séquence binaire (S2) qui lui est appliquée, le premier sélecteur de bits (20) sortant l'au moins un bit prédéterminé et une première séquence binaire qui ne comporte par l'au moins un bit prédéterminé,
un premier codeur (22), couplé au premier sélecteur de bits (20) pour coder l'au moins un bit prédéterminé et sortir une deuxième séquence binaire qui correspond à l'au moins un bit prédéterminé qui a été codé par le premier codeur (22),
des premier et deuxième codeurs de détection d'erreurs (62a, 62b) qui sont connectés l'un à l'autre en parallèle,
un premier moyen de commutation (60) couplé de façon à recevoir la première séquence binaire et l'au moins un bit prédéterminé, le premier moyen de commutation (60) appliquant de façon sélective la première séquence binaire à l'un des premier et deuxième codeurs de détection d'erreurs (62a, 62b) en fonction de l'au moins un bit prédéterminé,
un premier multiplexeur de bits (24) couplé de façon à combiner la deuxième séquence binaire et l'une des sorties des premier et deuxième codeurs de détection d'erreurs (62a, 62b), le premier multiplexeur de bits (24) sortant une séquence binaire combinée (A), et
un deuxième codeur (26) pour effectuer un codage convolutionnel de la séquence binaire combinée et donner une troisième séquence binaire qui est transmise au récepteur de données (12) par l'intermédiaire de la voie de transmission (14).

**3.** Appareil selon la revendication 2, dans lequel le récepteur de données comporte :

un premier décodeur (28) pour décoder la troisième séquence binaire qui lui est appliquée sur la voie de transmission, en utilisant un algorithme de Viterbi,
un deuxième sélecteur de bits (30), couplé au premier décodeur, pour choisir une quatrième séquence binaire dans une sortie du premier décodeur, la quatrième séquence binaire correspondant à la deuxième séquence binaire, le deuxième sélecteur de bits (30) sortant la quatrième séquence binaire et une cinquième séquence binaire qui ne comporte pas la quatrième séquence binaire,
un deuxième décodeur (32) couplé de façon à décoder la quatrième séquence binaire, le deuxième décodeur (32) sortant au moins un bit qui correspond à l'au moins un bit prédéterminé,
des premier et deuxième décodeurs de détection d'erreurs (64a, 64b) qui sont connectés l'un à l'autre en parallèle,
un deuxième moyen de commutation (64) couplé de façon à recevoir la cinquième séquence binaire et l'au moins un bit, le deuxième moyen de commutation (64) appliquant de façon sélective la cinquième séquence binaire à l'un des premier et deuxième décodeurs de détection d'erreurs (64a, 64b), en fonction de l'au moins un bit, et
un deuxième multiplexeur de bits (34) couplé de façon à combiner l'au moins un bit et une sortie de l'un des premier et deuxième décodeurs de détection d'erreurs (64a, 64b).

**4.** Appareil de codage de contrôle d'erreurs, comportant un émetteur de données (10) et un récepteur de données (12) interconnectés par l'intermédiaire d'une voie de transmission (14), l'émetteur de données comportant :

un premier sélecteur de bits (20) pour choisir au moins un bit prédéterminé dans une séquence binaire (S2) qui lui est appliqué, le premier sélecteur de bits (20) sortant l'au moins un bit prédéterminé et une première séquence binaire qui ne comporte pas l'au moins un bit prédéterminé,
un premier codeur (22), couplé au premier sélecteur de bits (20), pour coder l'au moins un bit prédéterminé et sortir une deuxième séquence binaire qui correspond à l'au moins un bit prédéterminé qui a été codé par le premier codeur (22),
un deuxième sélecteur de bits (70) couplé de façon à recevoir la première séquence binaire et l'au moins un bit prédéterminé, le deuxième sélecteur de bits (70) choisissant une troisième séquence binaire d'une longueur prédéterminée dans la première séquence binaire en fonction de l'au moins un bit prédéterminé, le deuxième sélecteur de bits (70) sortant une quatrième séquence binaire qui ne comporte pas la troisième séquence binaire,
un codeur de détection d'erreurs (72) qui reçoit la troisième séquence binaire et y ajoute des bits redondants, le codeur de détection d'erreurs (72) sortant une cinquième séquence binaire qui comporte la troisième séquence binaire et les bits redondants,
un premier multiplexeur de bits (24) couplé de façon à combiner les deuxième, quatrième et cinquième séquences binaires, le premier multiplexeur de bits (24) sortant une séquence binaire combinée, et
un deuxième codeur (26) permettant d'effectuer un codage convolutionnel de la séquence binaire combinée pour donner une sixième séquence binaire qui est transmise au récepteur de données (12) par l'intermédiaire de la voie de transmission (14).

**5.** Appareil selon la revendication 4, dans lequel le récepteur de données comporte :

un premier décodeur (28) pour décoder la sixième séquence binaire qui lui est appliquée sur la voie de transmission (14), en utilisant un algorithme de Viterbi,
un troisième sélecteur de bits (30), couplé au premier décodeur (28), pour choisir une septième séquence binaire dans une sortie du premier décodeur (28), la septième séquence binaire correspondant à la deuxième séquence binaire, le troisième sélecteur de bits (30) sortant la septième séquence binaire et une huitième séquence binaire qui ne comporte pas la septième séquence binaire,
un deuxième décodeur (32) couplé de façon à décoder la septième séquence binaire, le deuxième décodeur (32) sortant au moins un bit qui correspond à l'au moins un bit prédéterminé,
un quatrième sélecteur de bits (74) couplé de façon à recevoir la huitième séquence binaire du troisième sélecteur de bits (30) et à recevoir l'au moins un bit du deuxième décodeur (32), le quatrième sélecteur de bits (74) choisissant des neuvième et dixième séquences binaires qui correspondent respectivement aux quatrième et cinquième séquences binaires,
un décodeur de détection d'erreurs (76) agencé de façon à décoder la dixième séquence binaire, et
un deuxième multiplexeur de bits (34) couplé de façon à combiner l'au moins un bit du deuxième décodeur (32), la neuvième séquence binaire et une sortie du codeur de détection d'erreurs (76).

**6.** Procédé de contrôle d'erreurs comportant les étapes consistant à

choisir au moins un bit dans une séquence binaire initiale (S2), l'au moins un bit occupant une position quelconque dans la séquence binaire initiale,
coder l'au moins un bit pour former ainsi un bit codé,
combiner le bit codé à des bits de la séquence binaire initiale qui ne sont pas choisis pour former ainsi une deuxième séquence binaire (A),
effectuer un codage convolutionnel de la deuxième séquence binaire pour former ainsi une troisième séquence binaire (C),
décoder la troisième séquence binaire en utilisant un codage de maximum de vraisemblance pour former une quatrième séquence binaire, et
décoder la quatrième séquence binaire.

**7.** Procédé selon la revendication 6, dans lequel l'étape de choix comporte un bit de mode de la séquence binaire initiale.

**8.** Procédé selon la revendication 6, dans lequel l'étape de codage code un "0" logique sous la forme d'un "01" et code un "1" logique sous la forme d'un "10".

FIG. 1

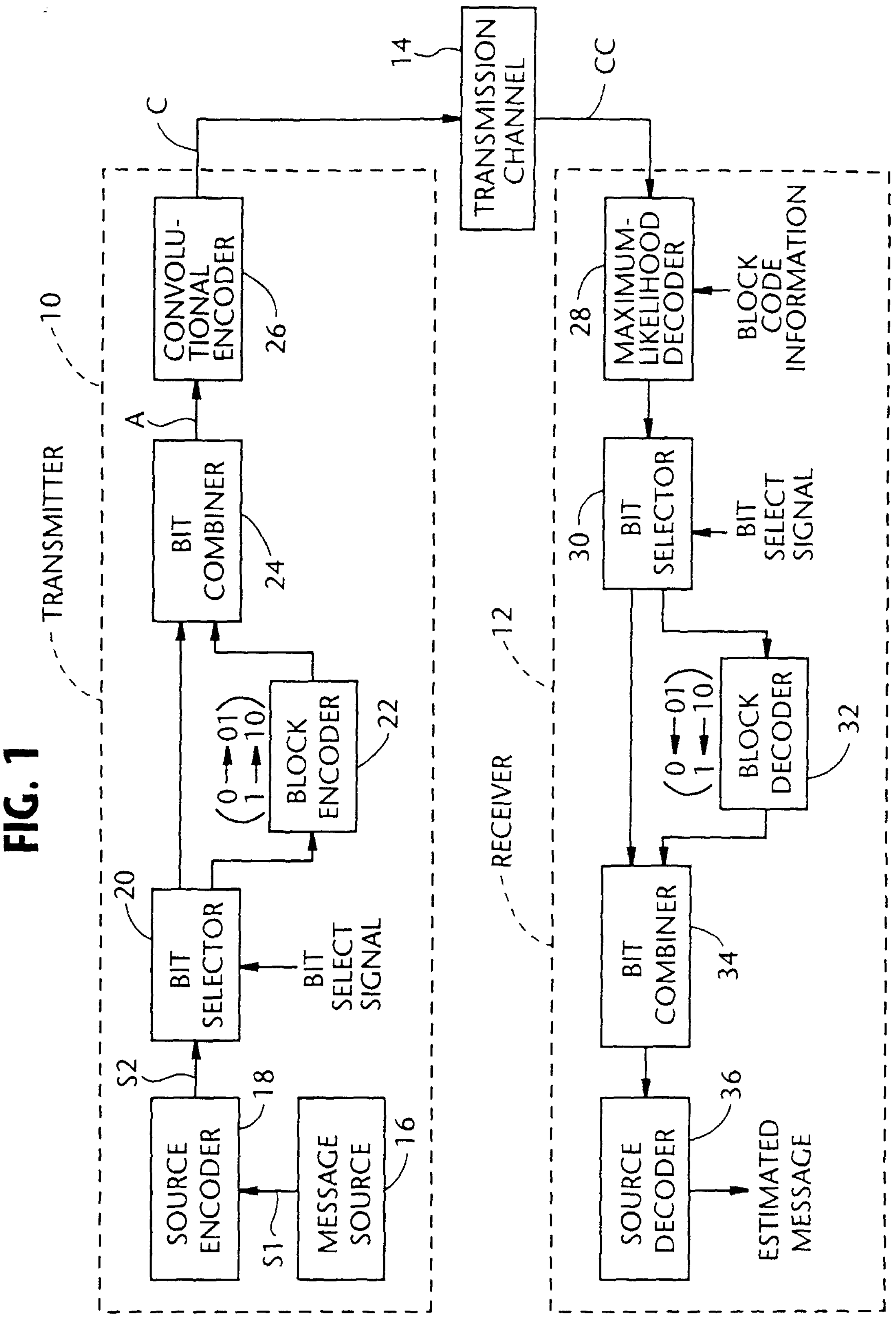
TRANSMITTER
10
MESSAGE SOURCE
16
S1
SOURCE ENCODER
18
S2
BIT SELECTOR
20
BIT SELECT SIGNAL
(0 → 01
1 → 10)
BLOCK ENCODER
22
BIT COMBINER
24
A
CONVOLU-TIONAL ENCODER
26
C
TRANSMISSION CHANNEL
14
CC
RECEIVER
12
MAXIMUM-LIKELIHOOD DECODER
28
BLOCK CODE INFORMATION
BIT SELECTOR
30
BIT SELECT SIGNAL
(0 ← 01
1 ← 10)
BLOCK DECODER
32
BIT COMBINER
34
SOURCE DECODER
36
ESTIMATED MESSAGE

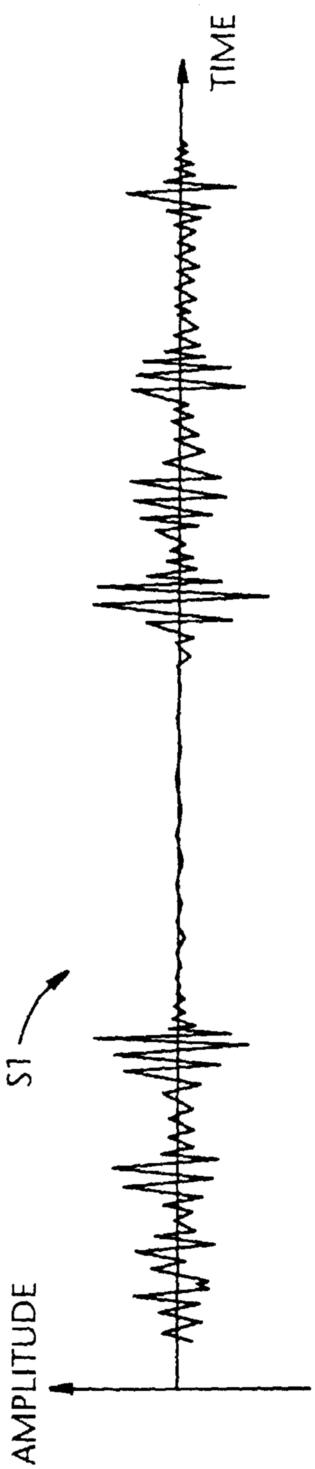
AMPLITUDE
TIME
S1

FIG. 2A

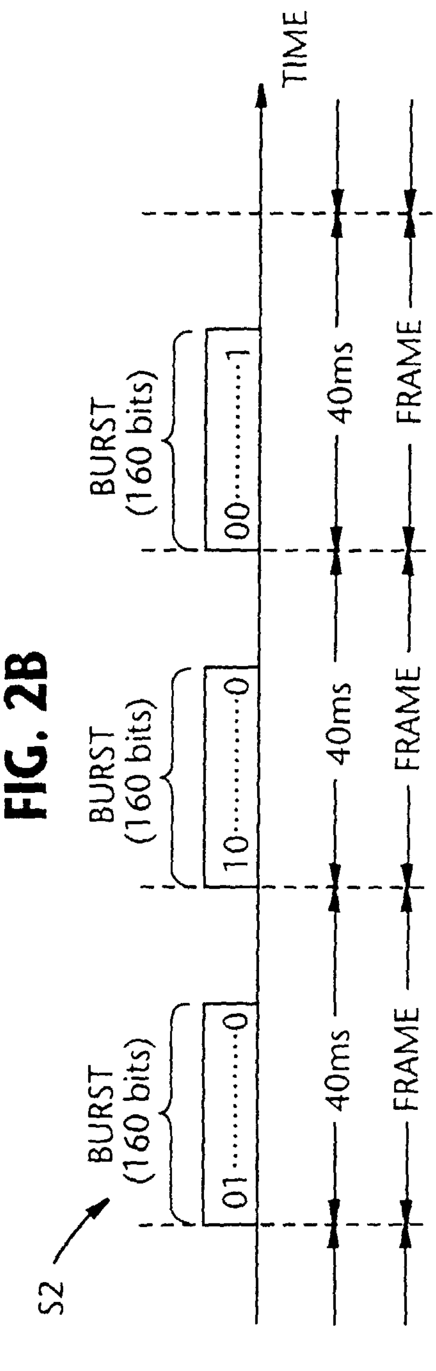
S2
TIME
BURST
(160 bits)
01..........0
10..........0
00..........1
40ms
FRAME

FIG. 2B

# FIG. 3

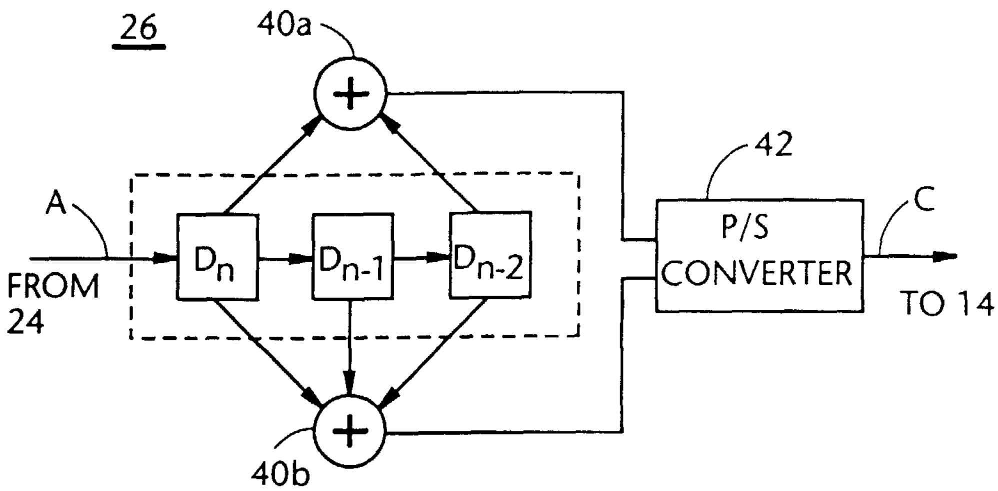
26
40a
A
FROM 24
$D_n$
$D_{n-1}$
$D_{n-2}$
42
P/S CONVERTER
C
TO 14
40b

# FIG. 4

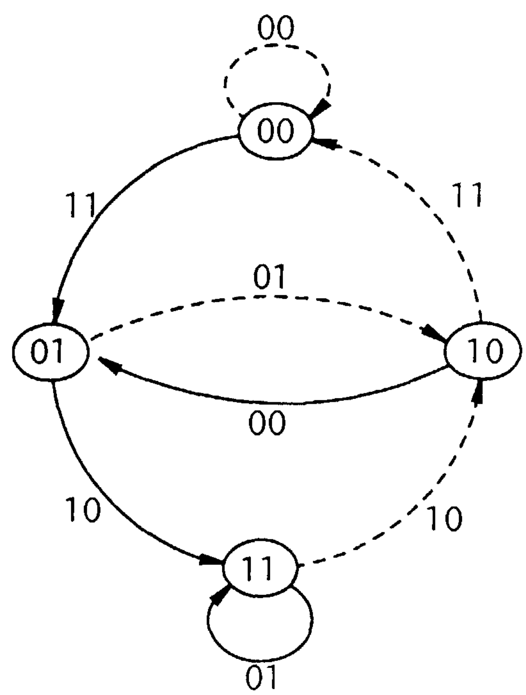
00
00
11
11
01
01
10
00
10
10
11
01

FIG. 5

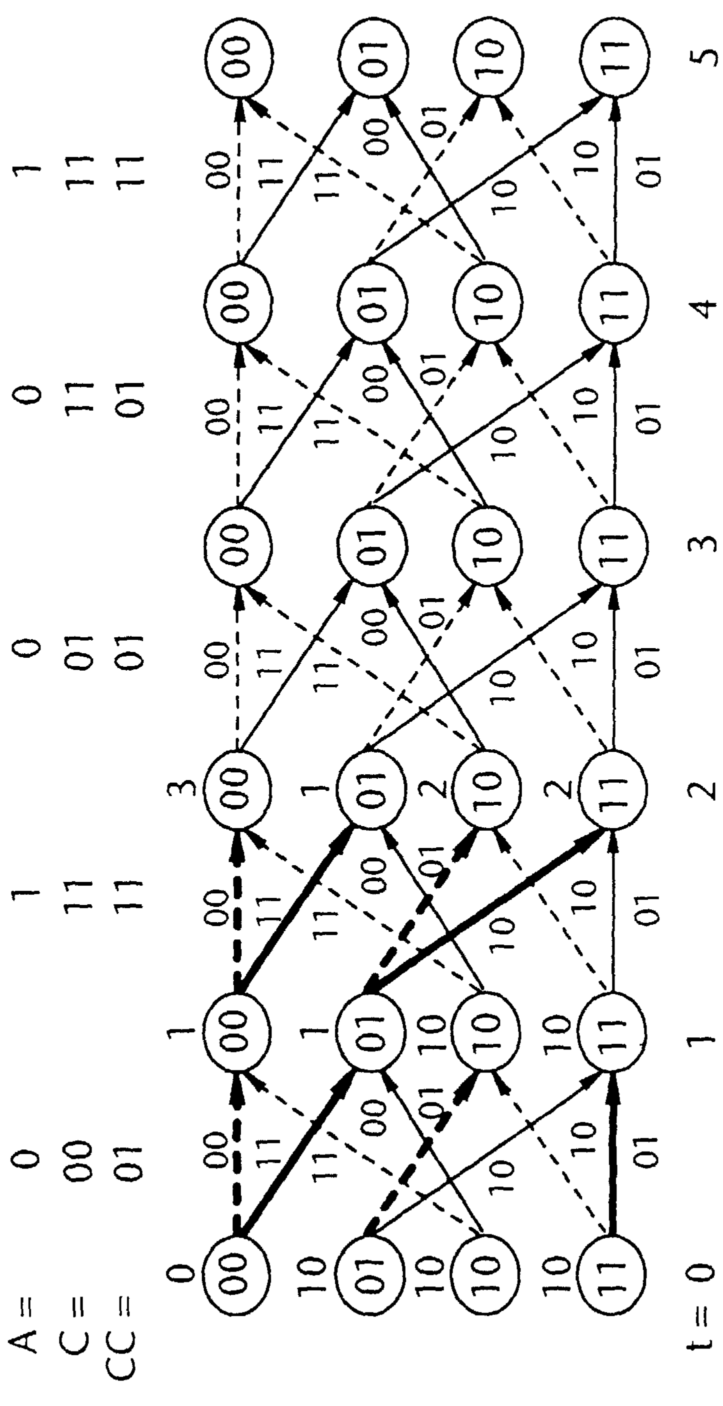

FIG. 6

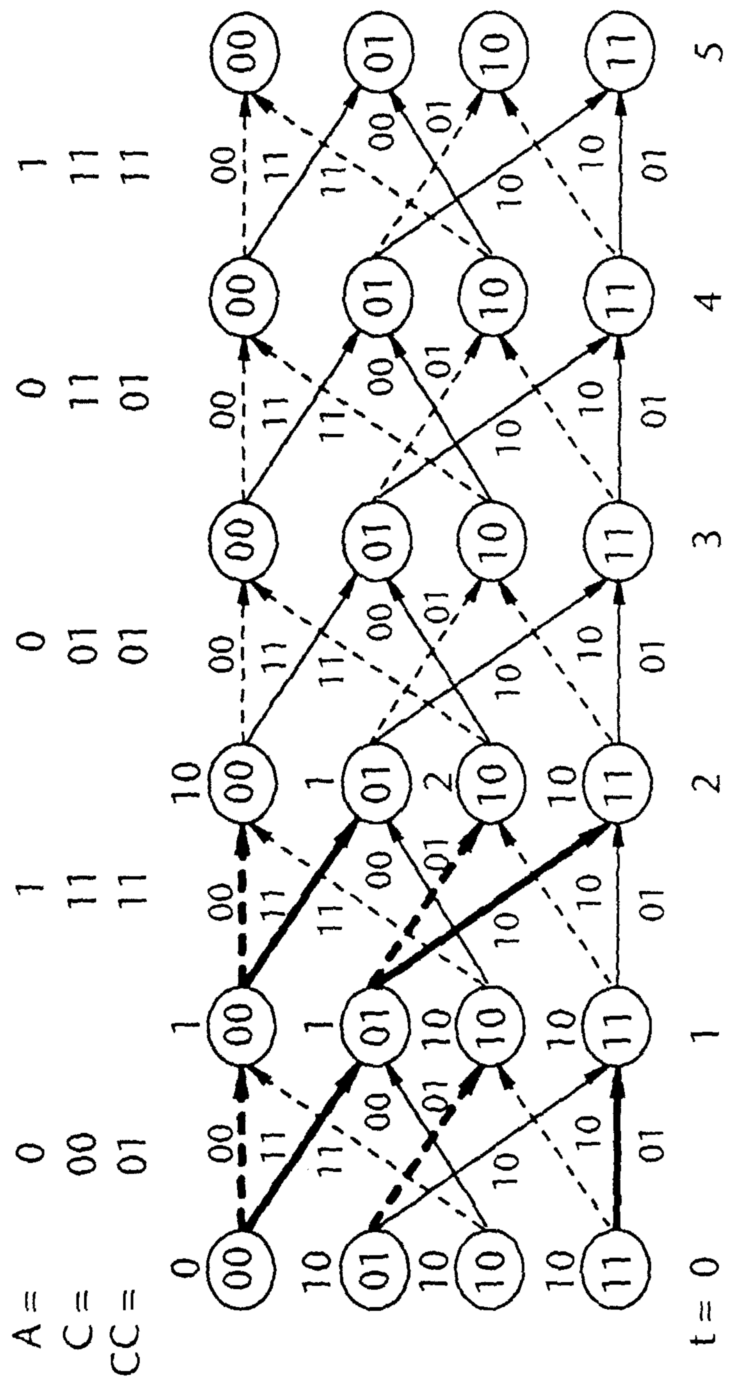

# FIG. 7

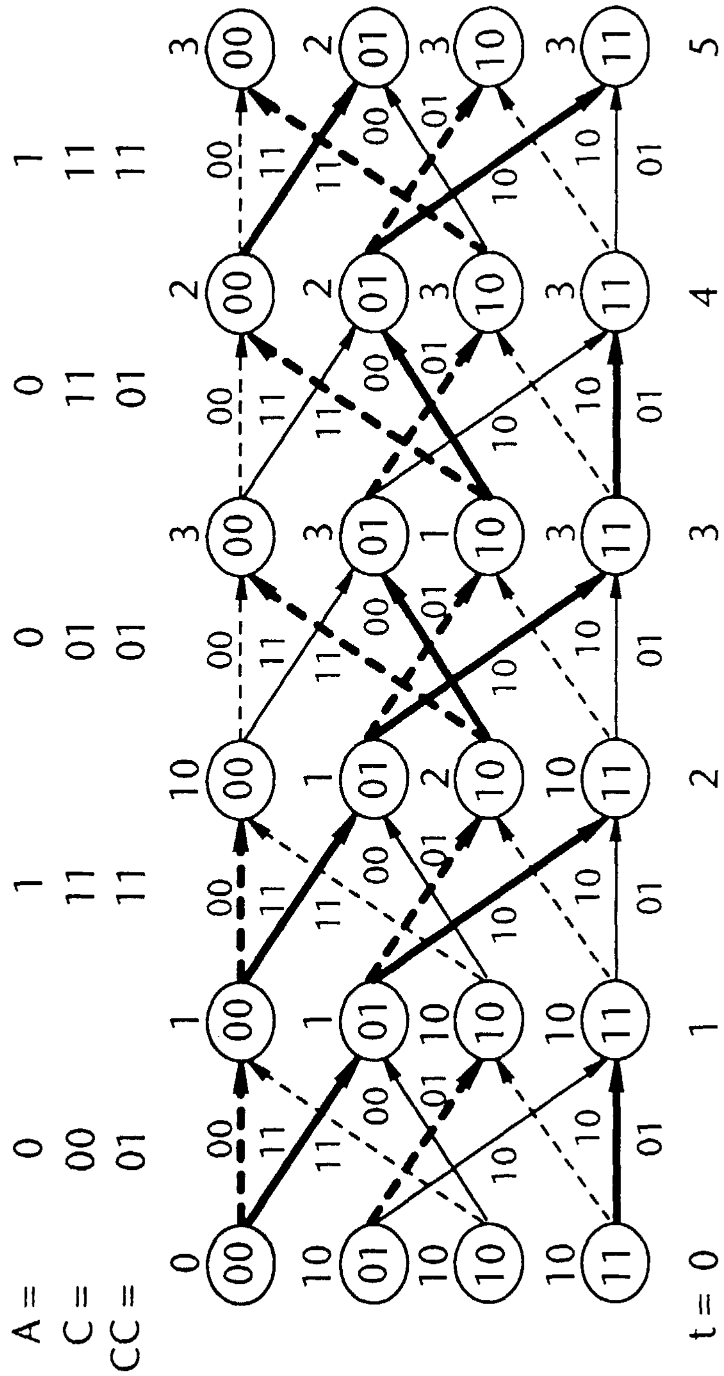

FIG. 8

TRANSMITTER

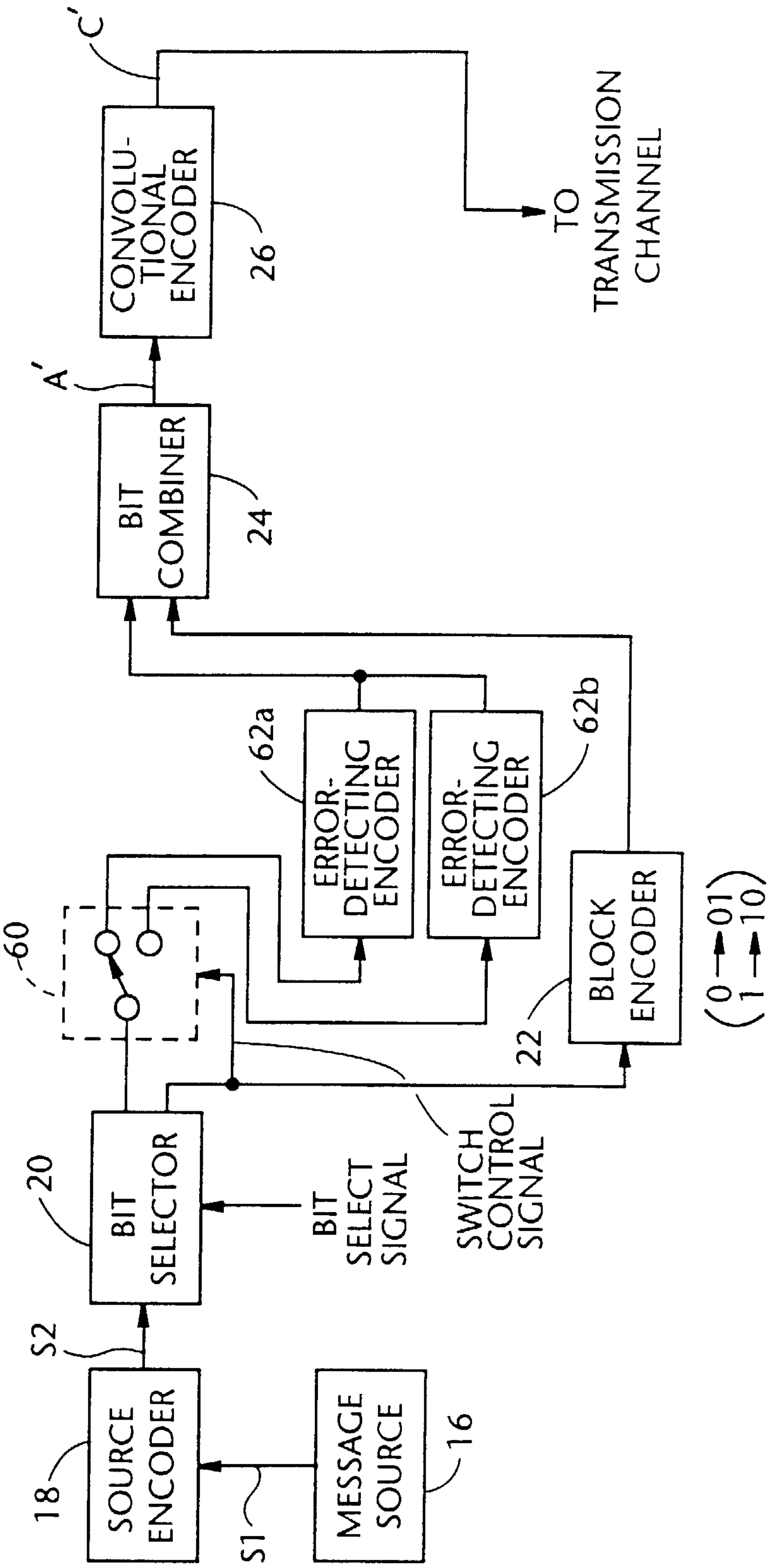

FIG. 9

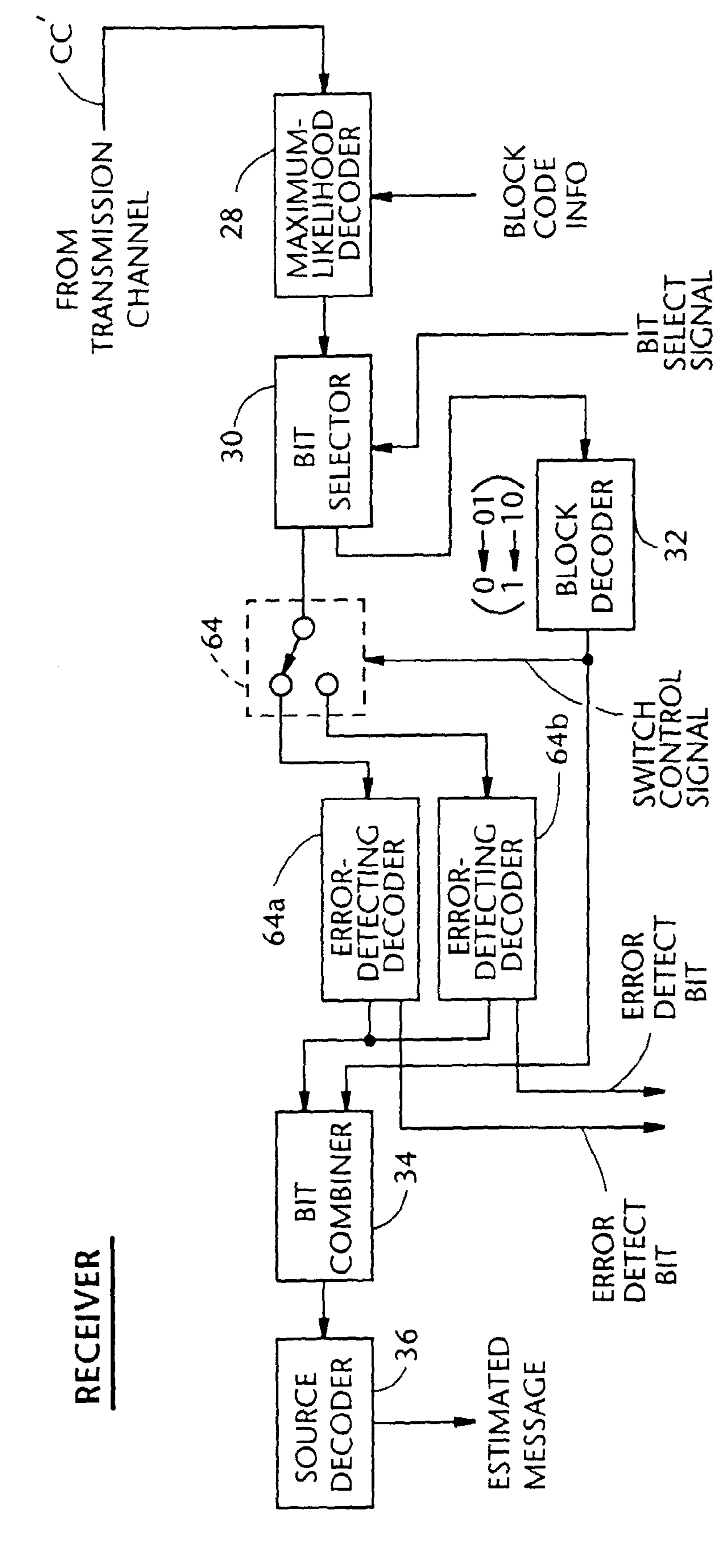
RECEIVER
FROM TRANSMISSION CHANNEL
CC'
28
MAXIMUM-LIKELIHOOD DECODER
BLOCK CODE INFO
30
BIT SELECTOR
BIT SELECT SIGNAL
BLOCK DECODER
32
(0 ← 01, 1 ← 10)
64
SWITCH CONTROL SIGNAL
64a
ERROR-DETECTING DECODER
64b
ERROR-DETECTING DECODER
ERROR DETECT BIT
ERROR DETECT BIT
BIT COMBINER
34
SOURCE DECODER
36
ESTIMATED MESSAGE

FIG. 10

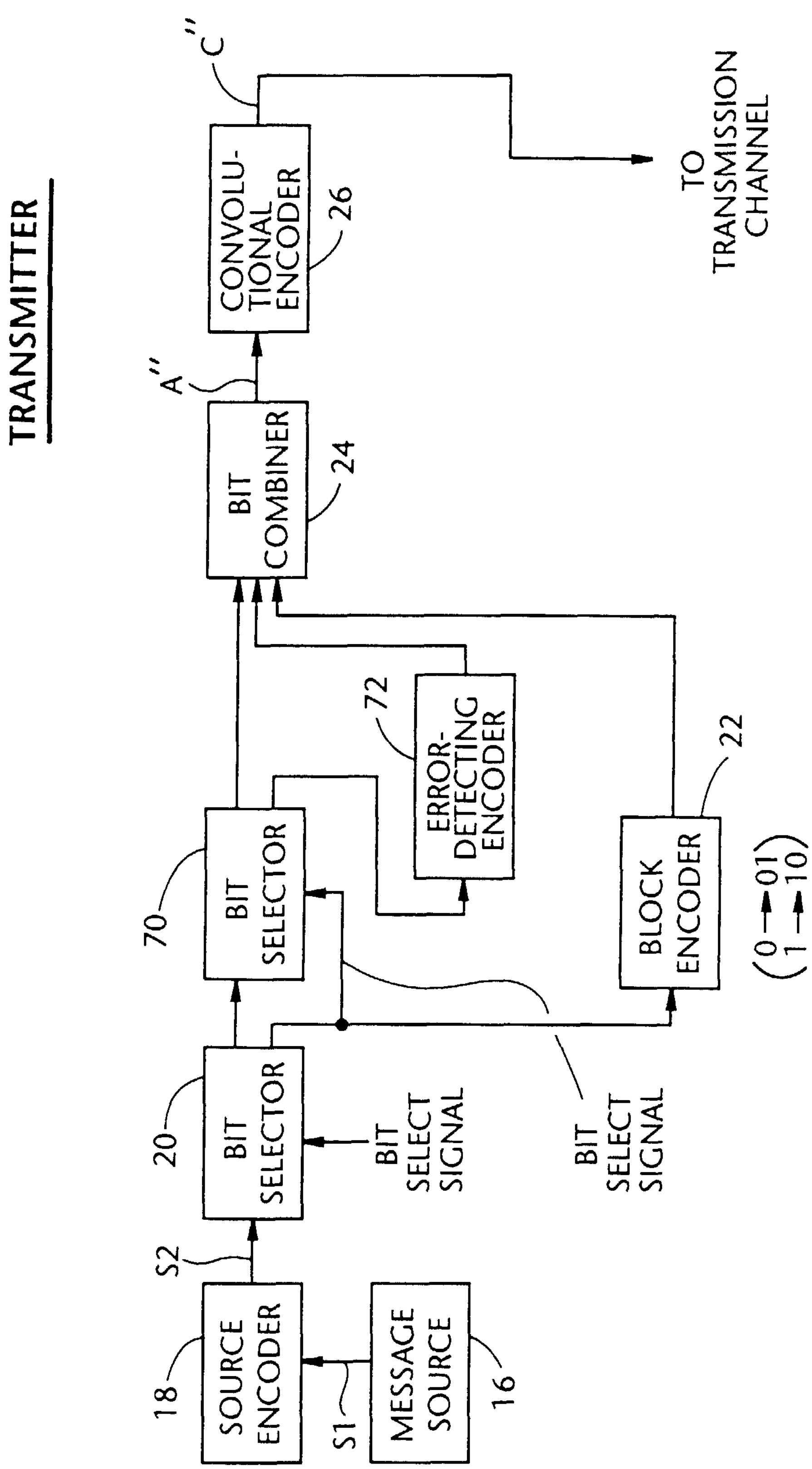
TRANSMITTER
MESSAGE SOURCE
16
S1
SOURCE ENCODER
18
S2
BIT SELECTOR
20
BIT SELECT SIGNAL
BIT SELECT SIGNAL
BIT SELECTOR
70
BLOCK ENCODER
22
(0→01
1→10)
ERROR-DETECTING ENCODER
72
BIT COMBINER
24
A''
CONVOLU-TIONAL ENCODER
26
C''
TO TRANSMISSION CHANNEL

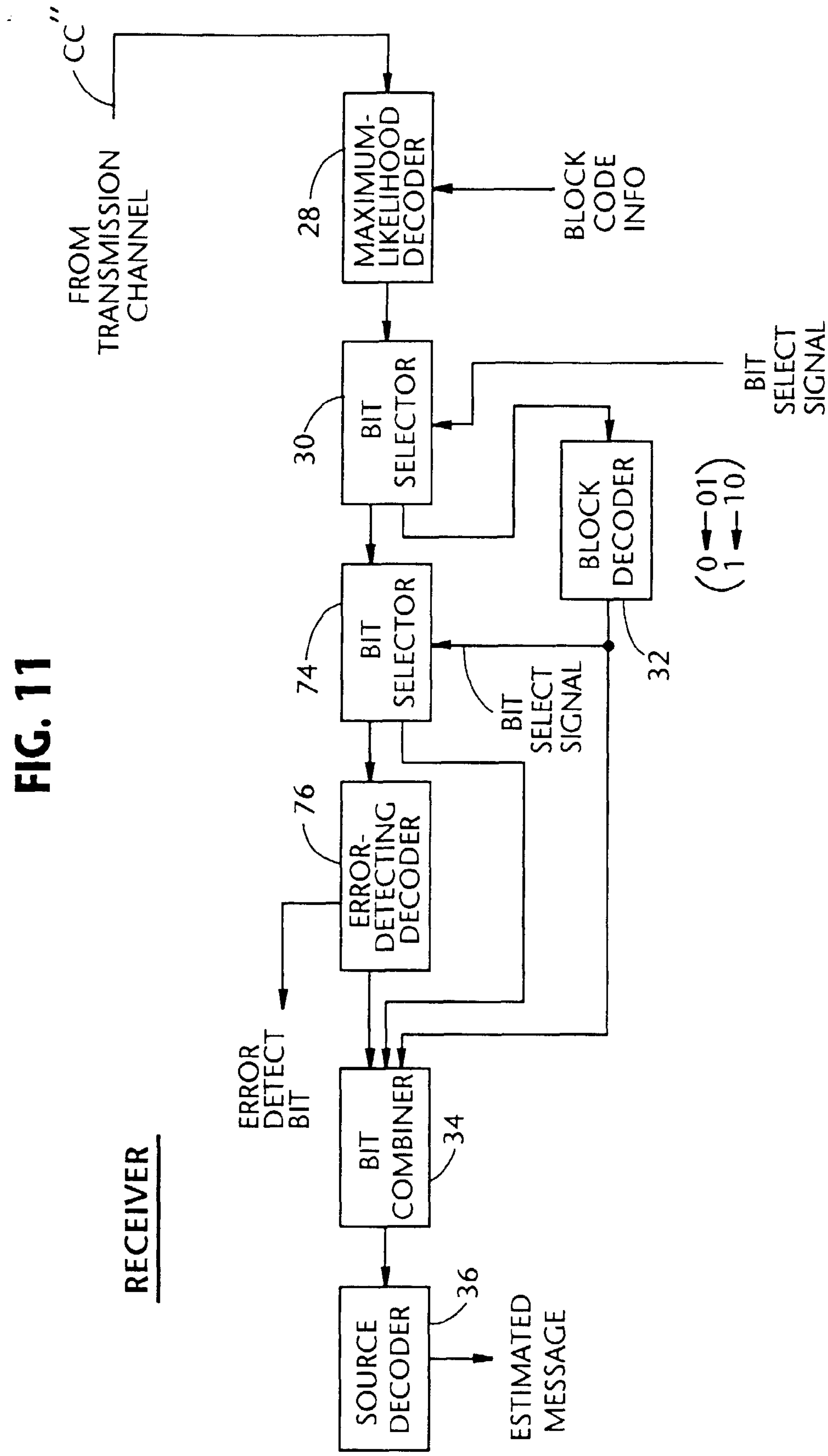
RECEIVER
FROM TRANSMISSION CHANNEL
CC''
28
MAXIMUM-LIKELIHOOD DECODER
BLOCK CODE INFO
30
BIT SELECTOR
BIT SELECT SIGNAL
BLOCK DECODER
32
(0 ⟵ 01
1 ⟵ 10)
74
BIT SELECTOR
BIT SELECT SIGNAL
76
ERROR-DETECTING DECODER
ERROR DETECT BIT
BIT COMBINER
34
SOURCE DECODER
36
ESTIMATED MESSAGE

FIG. 11